# EUROPEAN PATENT APPLICATION

(11) **EP 3 200 218 A1**
(43) Date of publication of application: **02.08.2017**
(21) Application number: 16153544.8
(22) Date of filing: 31.01.2016
(51) Int. Cl.: H01J 37/32, C23C 14/54

(54) **MONITORING DEVICE IN A VACUUM ENVIRONMENT**

(71) Applicant: Soleras Advanced Coatings bvba, 9800 Deinze (BE)
(72) Inventor: DE BOSSCHER, Wilmert, 9031 Drongen (BE); VAN DE PUTTE, Ivan, 8790 Waregem (BE)
(74) Representative: DenK iP

(57) **Abstract**

A housing (100) for mounting a monitoring device (150) in a process chamber. The housing (100) is formed such that it is mountable into the process chamber. It comprises a first opening (110) and a mounting point (140) adapted for mounting a monitoring device (140). The first opening (110) and the mounting point (140) are positioned such that, when the monitoring device (150) is mounted in the housing (100) at the mounting point (140), and when the housing (100) is mounted in the process chamber, during processing, radiation from the process chamber can reach the monitoring device (150) through the first opening (110) and such that the housing (100) protects the monitoring device against contamination or degradation as a result of the process.

## Description

### Field of the invention

The invention relates to the field of deposition and treatment, for instance plasma treatment, systems. More specifically it relates to systems and methods for monitoring emission (e.g. radiation from a plasma or other source) and its spectral composition when performing a PVD or CVD process in a non-atmospheric pressure regime.

### Background of the invention

While performing a PVD and/or CVD process, wanted and unwanted gasses may enter the process chamber through a variety of openings. To maintain stable plasma, particular gasses are added to the process chamber or are removed therefrom. In order to accurately regulate the quantity of gasses which are added and/or removed from the plasma, it is desirable that the plasma composition is well known.

In prior art systems the gas composition of the plasma may for example be determined by means of a mass spectrometer. Such a mass spectrometer can for example be a quadrupole, which is a bulky device. Such device measures the gas composition at a single location.

Another possibility is to use lambda probes. The lambda probes are brought into the process chamber and measure the oxygen concentration. For example 3 to 6 lambda probes may be installed in a large process chamber. Because of the limited number of probes and because of the shielding of the probes it is not possible to determine the gas composition over different dimensions.

In yet another prior art system photo multipliers are used to measure the emission spectrum of the plasma. In these systems the different excitation lines are analysed to determine the gas composition. The gas can for example comprise O, O₂, N, N₂, Ar. In the measured emission spectrum, absorption/emission peaks may be present which are caused by the excited material (e.g. Si). Prior art systems sometimes make use of a band pass filter such that only a limited bandwidth of the emission spectrum is measured. The width or intensity of the peaks may be measured, so as to determine the intensity of each of the gasses in the composition.

Photo multipliers comprise an optical fiber and an optical lens mounted on the optical fiber. The plasma or substrate can be monitored through the lens. To prevent the lens from being contaminated by the deposition or treatment process a collimator is positioned in front of the lens. The collimator, e.g. a high aspect ratio tube, thereby intercepts the deposition or other particles (e.g. coating particles) before they reach the lens. A gas flow, such as a flow of Ar gas, may be provided in the collimator so as to prevent deposition or other particles from entering the collimator.

### Summary of the invention

It is an object of embodiments of the present invention to provide a system and method for obtaining information from the emission coming from a process chamber. This can for example be spectral data or more specific the composition of a plasma in a process chamber while performing a PVD and/or CVD process. Embodiments of the present invention can for example be used to monitor sputter processes or for measuring an optical property of a deposited coating. It is an advantage of embodiments of the present invention that they can be used for measuring the coating on a substrate and/or for measuring radiation in a process (e.g. excitation light from a plasma).

The above objective is accomplished by a method and device according to embodiments of the present invention.

In a first aspect, the present invention provides a housing for mounting a monitoring device in a process chamber. The housing comprises a first opening and a mounting point adapted for mounting a monitoring device. The first opening and the mounting point are positioned such that, when the monitoring device is mounted in the housing at the mounting point, and when the housing is mounted in the process chamber, during processing, emission from the process chamber can reach the monitoring device through the first opening. At the same time, the housing protects the monitoring device against contamination or deterioration originating from the process.

It is an advantage of embodiments of the present invention that a monitoring device, for monitoring the emission from the process chamber, can be positioned in the process chamber by means of a housing according to embodiments of the present invention. By putting the monitoring device in the mounted housing, the monitoring device is protected from the deposition or other particles which would otherwise damage the monitoring device (any kind of deterioration originating from the process in the process chamber). The only opening through which the particles can reach the monitoring device is through the first opening through which the emission (e.g. light), which is monitored by the monitoring device, is coming. The housing thus reduces the contamination, caused by the process (e.g. coating like sputtering or treatment), of the at least one monitoring device. It is an advantage of embodiments of the present invention that the deposition or treatment process is not disturbed by the presence of the housing comprising the monitoring device(s). It is an advantage of embodiments of the present invention that a simple housing can be used with on one side the first opening and on the other side the mounting point. An advantage thereof is that the mounting point and the first opening can be easily aligned.

A housing according to embodiments of the present invention may comprise a light guiding element mounted into the first opening in the housing, wherein the light guiding element is hollow in its longitudinal direction. When a monitoring device is mounted in the housing, emission from the process chamber can reach the monitoring device through the light guiding element.

The light guiding element may be a bolt having a hole in its longitudinal direction.

It is an advantage of embodiments of the present invention that by adding a hollow bolt to the housing the contamination of the monitoring device by particles coming from the process chamber can be decreased even more while at the same time having a hole through which the emission (e.g. plasma light) can reach the monitoring device. It is an advantage of embodiments of the present invention that a bolt can be easily replaced by a new bolt by unscrewing the bolt and screwing a new one. If the bolt is coated by the deposition or treatment process it can therefore be easily replaced with a new, clean, bolt.

In embodiments of the present invention, the hole in the bolt may have an increasing diameter which, when mounted, increases from the inside of the housing towards the outside of the housing.

It is an advantage of embodiments of the present invention that the monitoring device has a wide viewing angle on the emission thanks to the increasing diameter of the hole in the bolt. In embodiments of the present invention, depending on the focusing, the viewing angle can vary from 0° (parallel beam) to 45° or more.

In embodiments of the present invention the diameter of the hole in the bolt may be increasing in discrete steps or in steps having a chamfer. It is an advantage of embodiments of the present invention that the hole in the bolt can be easily made. This can for example be done by using drills with different diameters.

In embodiments of the present invention, the monitoring device may comprise a lens. When the monitoring device and the bolt are mounted in the housing, the focal point of the lens may be inside the hole in the bolt and the diameter of the bolt may start increasing from this focal point onwards.

It is an advantage of embodiments of the present invention that the smallest diameter of the hole in the bolt is at the focal point of the lens. This permits to have a wide viewing angle while having at the same time a small diameter (the diameter at the focal point). The small diameter prevents contamination of the lens by the deposition or other particles. The wide viewing angle improves the monitoring of the emission (e.g. plasma radiation) over a wider spatial region.

In a housing according to embodiments of the present invention, the first opening may be the mounting point.

It is an advantage of embodiments of the present invention that the mounting point is integrated in the light guiding element. This decreases the complexity of the housing. In embodiments of the present invention the light guiding element and the monitoring device may be integrated in one piece. It is an advantage thereof that this ensures a good alignment between the monitoring device and the light guiding element.

A housing according to embodiments of the present invention may comprise a second opening on the side of the housing opposite to the side of the first opening, wherein the second opening is the mounting point.

It is an advantage of embodiments of the present invention that the housing can have a simple shape. In embodiments of the present invention it is not required to cast the housing in a complex form. By aligning the first opening and the second opening, radiation entering through the first opening reaches the monitoring device mounted in the corresponding second opening.

A housing according to embodiments of the present invention may comprise a protective sheet mountable between the first opening and the mounted monitoring device or mountable in front of the first opening and the monitoring device.

It is an advantage of embodiments of the present invention that a monitoring device is protected from being contaminated by particles from the process chamber by a protective sheet in between the monitoring device and the first opening in the housing or mountable in front of the opening. In the last case the opening is between the sheet and the monitoring device. This protective sheet can for example be made of glass or another light permeable material. It can also be made of light impermeable material. In that case holes are made in the protective sheet to let the emission pass through.

A housing according to embodiments of the present invention may be an elongated housing comprising a plurality of first openings and mounting points such that emission from the process chamber can reach a plurality of monitoring devices when they are mounted at the mounting points of the housing.

It is an advantage of embodiments of the present invention that by mounting this type of housing into a process chamber, a plurality of monitoring devices can be mounted simultaneously into the process chamber. It is an advantage of embodiments of the present invention that the gas composition can be measured over at least one dimension. Using the elongated housing it is possible to measure over the length dimension of the housing. By for example putting more than one housing in the process chamber and by putting them parallel with each other or by making a single housing rotatable around a longitudinal axis it is also possible to measure in a second dimension orthogonal to the length dimension of the housing.

A housing according to embodiments of the present invention may comprise a gas purge connector. It is an advantage of such embodiments of the present invention that a gas pipe can be connected to the housing via the gas purge connector. This allows to pressurize the housing with a certain gas (e.g. argon). By having a higher pressure on the inside than on the outside of the housing, contamination of the at least one monitoring device in the housing by particles in the process chamber (e.g. particles of the sputtering process) can be reduced. By increasing the pressure in the housing the mean free path of the particles inside the housing is reduced.

In a housing according to embodiments of the present invention, at least a first part of the housing has an opening which is mountable against an opening in the wall of the process chamber. This first part of the housing is sealed from the process chamber, such that when the housing is mounted in the process chamber with the opening sealed against the opening of the process chamber, a pressure difference can be present between this first part of the housing and the process chamber. The system is then designed such that this pressure difference will not result in a gas flow from the inside of the first part of the housing into the process chamber.

It is an advantage of embodiments of the present invention that the pressure inside the first part of the housing can be atmospheric (or a pressure significantly different from the pressure in the process chamber) while the pressure in the process chamber can be low (e.g. a vacuum pressure in the process chamber). In embodiments of the present invention, the first part of the housing can be the complete housing. It is an advantage of embodiments of the present invention that fibers towards the monitoring devices can be protected by the first part of the housing. Since this first part can be connected to an opening in the process chamber, the fibers can enter the housing directly though this opening and no expensive feedthrough component is required which enables the feed through of the fibers into the process chamber. It is an advantage of embodiments of the present invention that through the opening in the process chamber (to which the first part of the housing is connected) a plurality of fibers can be inserted into the first part of the housing. Vacuum feedthrough components only have a limited number of feedthrough fibers and have the disadvantage that it is difficult to add a fiber later on. Moreover, a feedthrough component introduces a significant loss in the signal intensity which can be between 10% and 40% of the total signal. As a result, a signal may typically loose about 50% by having a double connection (an optical fiber needs to be connected at both sides of the feedthrough, with the disadvantage that each connection has a loss) for bringing it to vacuum. It is an advantage of embodiments of the present invention that no feedthrough component is required for entering the process chamber. The fiber can directly enter the process chamber through the opening, thus removing the need for a feedthrough component at this place, and thus decreasing the signal loss. It is an advantage of embodiments of the present invention that a direct connection is possible between the monitoring device (e.g. collimator lens) and the processing system (e.g. spectrometer). During operation, the first part of the housing can be in atmospheric pressure, while vacuum is present in the rest of the process chamber. The fibers in the first part of the housing are therefore protected by the first part of the housing (e.g. against outgassing, against direct heat from the process chamber (e.g. caused by the plasma)). Since the fibers are protected by the first part of the housing, it is not required to provide a special shielding (e.g. a metal shielding) for the fibers and standard fibers can be used. Thus extra costs for special shielding are prevented thanks to embodiments of the present invention. The diversity of fibers for a total system will therefore be smaller when using a housing in accordance with embodiments of the present invention. It is an advantage of embodiments of the present invention that single fibers can be adjusted and replaced without impacting the whole system. It is an advantage that monitoring devices which are not suitable for operating under vacuum conditions or monitoring devices which are not suitable for operating under particular radiation or material and gas fluxes can be positioned in the protective environment of a housing in accordance with embodiments of the present invention.

A housing according to embodiments of the present invention may comprise a first part comprising the mounting point for mounting the monitoring device and a second part comprising the first opening. The second part can be mounted around or in front of the first part. The second part can be shifted in the longitudinal direction and/or rotated with regard to the first part such that, when the housing is mounted in the processing chamber, during processing, the opening in the second part can be positioned such that emission can reach the monitoring device through the first opening or the first opening can be moved away such that the shielding of the monitoring device by the second part is enhanced.

It is an advantage of embodiments of the present invention that, by rotating and/or shifting the second part with regard to the first part, either emission can reach the monitoring device or shielding can be enhanced. Both the first part and the second part can have a cylindrical shape, which has the advantage that they can easily rotate with regard to each other. It is an advantage of embodiments of the present invention that no additional protective sheet is required, although it can be present. The second part itself can also serve as protective sheet by moving it in the position in which it protects the monitoring devices.

In a second aspect, the present invention provides a deposition and/or treatment system comprising a housing according to any of embodiments of the first aspect, mounted in a process chamber such that, in operation, the at least one first opening in the housing is orientable towards the emission such that, when a monitoring device is mounted in the housing, it has a viewing angle on the emission from within the process chamber.

It is an advantage of embodiments of the present invention that by mounting the housing, the at least one monitoring device inside the housing is correctly mounted inside the process chamber and that the housing is orientable such that the monitoring device has a viewing angle on the emission from the process chamber. This may for example be a plasma monitoring device having a viewing angle on the plasma.

In a deposition and/or treatment system according to embodiments of the present invention, the housing is mountable such that the first opening is orientable away from the emission from the process chamber.

It is an advantage of embodiments of the present invention that the at least one monitoring device can be protected from being damaged by the deposition or other particles by orienting the first openings away from the emission (e.g. the plasma radiation).

In a deposition and/or treatment system according to embodiments of the present invention, the housing may be translationally or rotatably movably mounted in the process chamber.

It is an advantage of embodiments of the present invention that the emission (e.g. the plasma radiation) can be scanned by rotating the housing. As such, in embodiments of the present invention, it is possible to measure the emission in a first dimension along the elongated housing and in a second dimension orthogonal to the first dimension. Moreover, in embodiments of the present invention the housing can be translated or rotated so much that the at least one first opening in the housing is oriented away from the emission source.

In a deposition and/or treatment system according to embodiments of the present invention, the housing may be mounted such that, in operation, when a substrate is in the process chamber, the substrate is in between the emission source and the housing.

It is an advantage of embodiments of the present invention the substrate in between the emission source (e.g. the plasma) and the housing protects the monitoring device from being damaged by the emission. The emission source might for example be a plasma source in which case the radiation from the plasma goes through the substrate and can reach the monitoring device through the substrate.

In an alternative deposition and/or treatment system according to embodiments of the present invention, wherein the housing may be mounted such that, in operation, when a substrate is in the process chamber, the emission source and the housing are at the same side of the substrate.

It is an advantage of embodiments of the present invention that the monitoring device is not impacted by direct emission from the emission source (which may for example be the plasma or a separate emission source). The measurement may for example be intended for evaluating the plasma composition or for evaluation the substrate (which may have a coating on top of it).

In a third aspect, the present invention provides a measurement system for determining the the emission characteristics in a process chamber. The measurement system comprises:
- a housing according to any of the embodiments of the first aspect of the present invention, the housing being mountable in the process chamber,
- at least one monitoring device mountable in the housing and adapted for measuring the spectrum of the emission,
- a processing system adapted for processing a measurement signal, e.g. a spectrum, measured by the at least one monitoring device, thereby determining physical properties of the emission monitored by the monitoring device.

It is an advantage of embodiments of the present invention that the physical properties of the emission (e.g. plasma or light source radiation) monitored by the monitoring device can be determined. In case of plasma, this can for example be the plasma composition by measuring the radiation peaks at specific wavelengths corresponding with energetic shifts of electrons from excitation states within the atomic structure of the resident species in the process chamber. In case of a light source, this can for example be the spectral interference pattern generated by a layer stack on the substrate and measured by reflection on or transmission through the substrate.

In a measurement system according to embodiments of the present invention, the processing system may be adapted for processing the measurement signals taking into account the measurement signal changes which are caused by the presence of an intermediate substrate.

It is an advantage of embodiments of the present invention that the influence of the intermediate substrate on the measurement signals (e.g. measured spectrum) is accounted for when determining the physical properties of the emission (e.g. the plasma radiation).

In a measurement system according to embodiments of the present invention, the processing system may be adapted for controlling the position of the housing in the process chamber.

It is an advantage of embodiments of the present invention that the measurement system can scan the emission by controlling the position of the housing in the process chamber. The measurement system is therefore able to measure and process the spectrum of the emission at a certain place after which the processing system can change the position of the housing in order to monitor another part of the radiation.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a cross-section of a housing comprising a first sealed part, in accordance with embodiments of the present invention.
FIG. 2 shows a cross-section of a housing comprising a first sealed part and a light guiding element, in accordance with embodiments of the present invention.
FIG. 3 shows a cross-section of a housing comprising a protective cap in accordance with embodiments of the present invention.
FIG. 4 shows a 3D view of a housing in accordance with embodiments of the present invention.
FIG. 5 shows a 3D view of a housing comprising a gas purge connector in accordance with embodiments of the present invention.
FIG. 6 shows the cross-section of a housing comprising a light guiding element, wherein the light guiding element comprises the mounting point, in accordance with embodiments of the present invention.
FIG. 7 shows the cross-section of a housing as in FIG. 6, the housing additionally comprising a shielding part around the first part, provided with an opening for allowing process light to enter the housing, in accordance with embodiments of the present invention.
FIG. 8 shows the cross-section of a housing as in FIG. 6, the housing additionally comprising a shielding part not completely surrounding the first part, provided with an opening for allowing process light to enter the housing, a glass being present in the opening of the shielding part, in accordance with embodiments of the present invention.
FIG. 9 shows the cross-section of a housing as in FIG. 7, the housing additionally comprising a light guiding element mounted in the opening of the shielding part, in accordance with embodiments of the present invention.
FIG. 10 schematically shows a plasma deposition and/or treatment system comprising a housing in accordance with embodiments of the present invention, positioned at the opposite side of the substrate relative to the position of the targets.
FIG. 11 schematically shows a plasma deposition and/or treatment system comprising a housing in accordance with embodiments of the present invention, positioned at the same side of the substrate relative to the position of the targets.
FIG. 12 shows a measurement system in accordance with embodiments of the present invention.
FIG. 13 illustrates an alternative embodiment of a hollow bolt for intercepting light when used in a housing according to embodiments of the present invention.
FIG. 14 shows a measurement system, wherein the fibers coming from the monitoring devices are leaving the process chamber using a feedthrough component, in accordance with embodiments of the present invention.
FIG. 15 shows a measurement system, wherein a first part of the housing has an opening sealed against an opening in the process chamber, in accordance with embodiments of the present invention.
FIG. 16 shows a measurement system as in FIG. 15, the housing moreover comprising a second part comprising a purge connector, in accordance with embodiments of the present invention.

The drawings are only schematic and are non-limiting. In the drawings, the size of some of the elements may be exaggerated and not drawn on scale for illustrative purposes.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to a monitoring device, reference is made to a device or part of a device which allows taking samples of emission in a process chamber. In embodiments of the present invention this device or this part of the device is protected by a housing. The emission may for example be radiation, such as for example light radiation or radiation coming from a plasma. The monitoring device may comprise a light source (e.g. a laser) as well as a detector. In that case the light source transmits radiation through the process chamber (e.g. through a substrate or reflecting on a substrate) and the detector captures the transmitted or reflected radiation. The monitoring device may be a plasma monitoring device which samples plasma emission, and enables a plasma analyser receiving such samples to perform an optical analysis of a plasma, e.g. to determine the composition of the plasma. The plasma analyser may have one or more input ports for receiving samples representative for the composition of the plasma at the location where the sample is taken by the plasma monitoring device. The monitoring device may comprise a light source and a detector. The detector samples can be received by a spectral analyser which can for example perform an optical analysis of a substrate, a coating or a combination of both; e.g. to determine a layer property of the substrate or a film deposited on the substrate. The analyser may have one or more input ports for receiving samples representative for the substrate or film at the location where the sample is taken by the monitoring device. Such monitoring device can for example be a lens for capturing the radiation emitted by the plasma or light source or a lens in combination with a collimator. The lens may for example have a diameter between 3 and 25 mm, for example 6 mm. In embodiments of the present invention the monitoring device may comprise a laser and corresponding detector, for instance for thickness or presence detection. The monitoring device may for example also be a Hall probe for detecting electrical or magnetic properties. The monitoring device may for example also be a spectrometer or an electronic probe or an electromagnetic radiation sensor or a part of any of these (more specifically, the part which is protected by the housing).

In yet another prior art system, specific spectral radiation may be introduced into the system and a detection system monitors if absorption or excitation occurs at specific wavelengths. This configuration may allow defining specific properties of the species that are located in between the radiation source and detection monitor.

Where in embodiments of the present invention reference is made to the first opening, reference is made to the opening through which emission from the process chamber can reach the monitoring device. This opening can be located in a first part of the housing and/or in a second part of the housing.

In a first aspect, the present invention provides a housing 100 for mounting at least one monitoring device 150 in a process chamber. The housing 100 is or comprises an elongated element, for instance an extrusion profile or more than one extrusion profile if the housing comprises more than one part, with any suitable shape of cross-section, for instance, but not limited thereto, a square or rectangular cross-section.

In embodiments of the present invention the length of the housing is between 0.5 and 5 m, for example between 1 and 4 m. The size of the cross-section of the housing 100 may for example range between 30x30 mm and 150x150 mm. The thickness of the material of the housing may for example be between 1 and 10 mm. It is an advantage of embodiments of the present invention that the housing 100 is rigid against deformation for example by a torsion force.

The housing 100 is formed such that it can be mounted in a process or vacuum chamber.

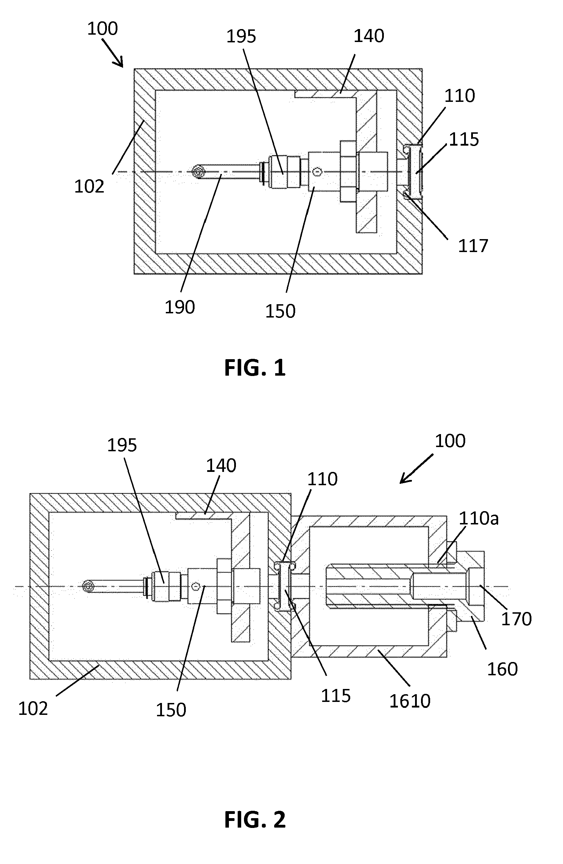

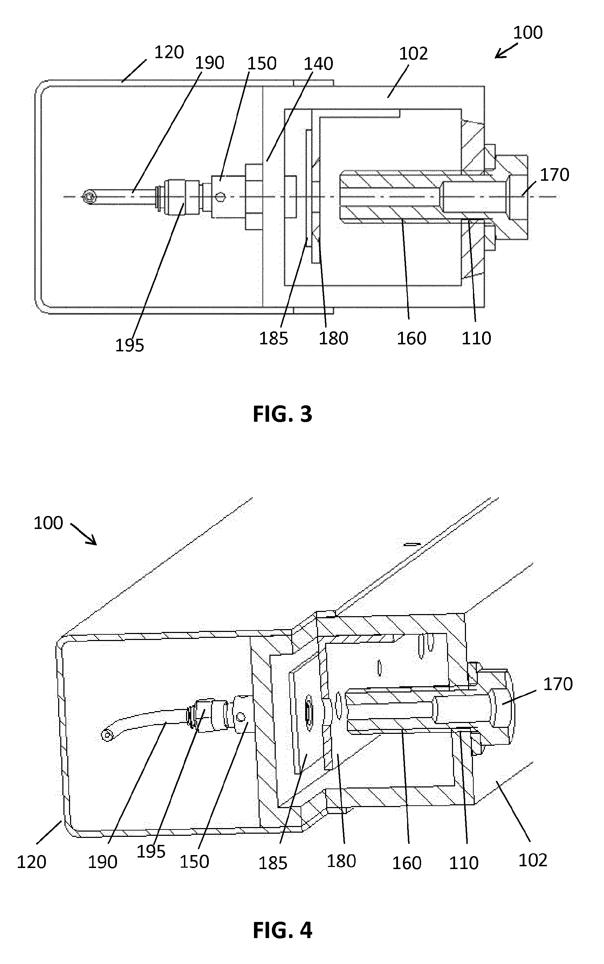

The housing is formed such that at least one, or possibly a plurality of monitoring devices can be mounted inside the housing and this in the length direction of the housing (direction perpendicular to the plane of FIG. 1). When equipped with one monitoring device, the emission spectrum can be measured on one location; when the housing 100 is equipped with a plurality of monitoring devices, the emission can be measured along one dimension. In embodiments of the present invention between 2 and 60, preferably between 5 and 25, for example 15 monitoring devices can be mounted in a single housing 100. Mounting points 140 or elements may be provided on (L-profile 140 in FIG. 1) or in (opening 140 in FIG. 3) the housing 100, to allow mounting of monitoring devices 150 on or in the housing 100. In embodiments of the present invention the distance between the mounting points for mounting the monitoring devices is between 5 and 100 cm, preferably between 10 and 50 cm, for example about 30 cm. In embodiments of the present invention a mounting point 140 may be an opening in the housing in which the monitoring device 150 can be fixed, for instance by screwing. In that case the wall of the housing 100 is preferably thick enough such that screw-thread can be pulled in the hole forming the mounting point 140. The thickness of the housing 100 may for example be about three millimetres. In embodiments of the present invention the housing 100 is made of rigid material, for instance metal, such as aluminium. It is an advantage of using aluminium housings that they have a limited weight and high mechanical strength.

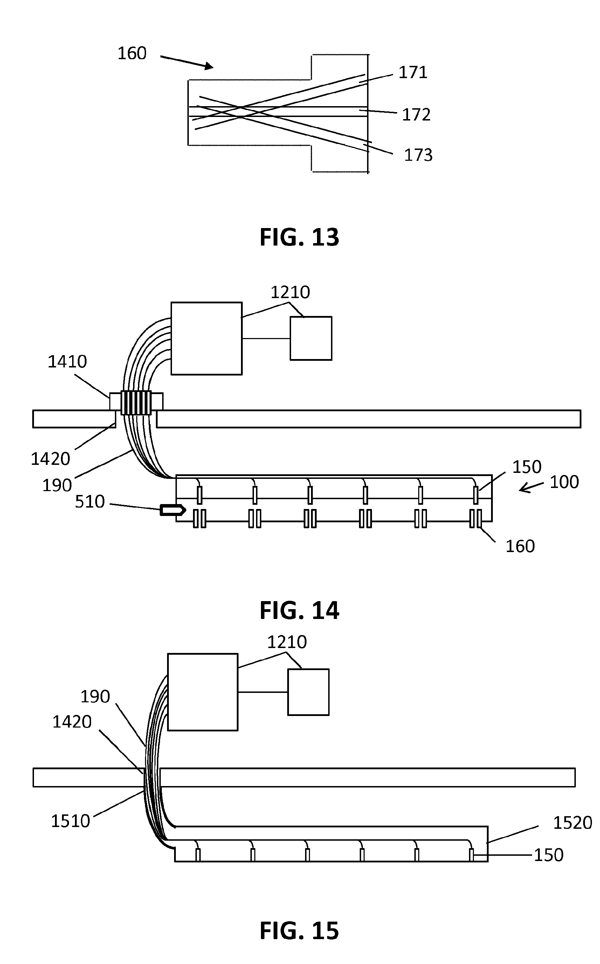

In embodiments of the present invention the housing 100 may have a first part 102. The first part 102 has an opening 1510 which can be sealed against an opening 1420 in a process chamber. Other openings 110 in the first part 102 are sealed such that an atmospheric pressure can be present on the outside of the process chamber and on the inside of the first part 102 of the housing 100 while at the same time a vacuum is present in the process chamber. The pressure difference between the inside of the first part 102 of the housing 100 and the inside of the process chamber does not result in a gas flow between both. In embodiments of the present invention, the first part 102 of the housing corresponds with the complete housing 100. The openings 110 can for example be sealed with a glass 115 such that light can still enter the housing 100 through the opening 110. The glass 115 can for example be fixed using an o-ring 117 which can be provided in the hole 110. FIG. 1 shows a cross-section of an exemplary embodiment of a housing according to the present invention comprising a sealed first part 102 of the housing 100. In this case the first part 102 is the complete housing. In the example, a monitoring device 150 is mounted at the mounting point 140, which is in this case an L-profile provided at an inner wall of the first sealed part 102. A longitudinal cross-section of such a housing is shown in FIG. 15. One end 1520 of the housing is closed, and the other end 1510 of the housing is mounted against an opening in the wall of the process chamber.

FIG. 2 shows the cross-section of a housing 100 in accordance with alternative embodiments of the present invention. The housing comprises a first sealed part 102, and a further part 1610 adjacent the first sealed part. The further part 1610 does not need to be, but may be, a sealed part. The first sealed part 102 comprises an opening 110, sealed with a glass 115 and an o-ring. In the example illustrated, a monitoring device 150 is mounted at the mounting point 140, which is in this case an L-profile provided at an inner wall of the first sealed part 102. FIG. 2 also shows a first opening 110a in the further part 1610, in which a light guiding element 160 is mounted. In this example the light guiding element 160 is a perforated bolt. The first openings 110a, 110, and the monitoring device are positioned and aligned such that radiation from the process chamber can reach the monitoring device through the first openings 110.

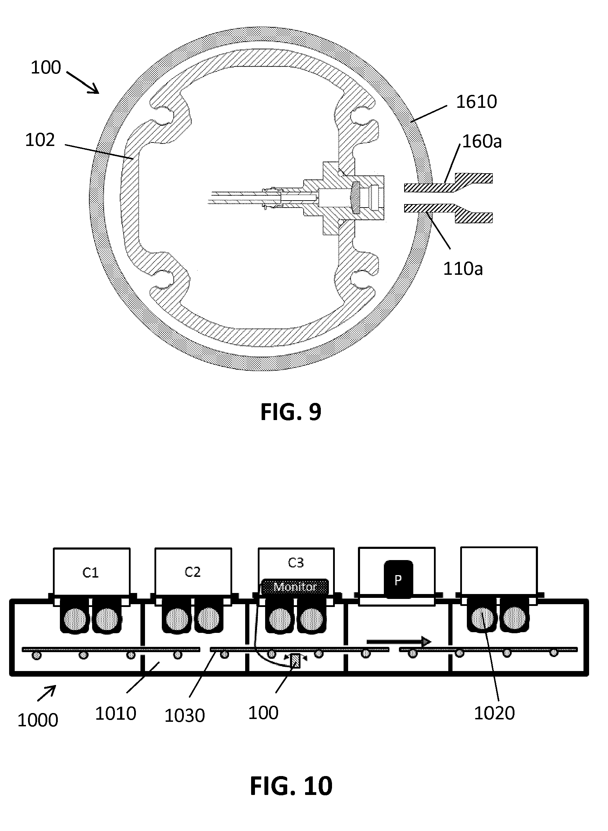

In embodiments of the present invention lenses and/or collimators can be mounted in the housing as the monitoring devices 150. This way, the lens is located at the inside of the housing 100, and using an optical fiber 190 captured light may be guided out of the process chamber 1010 (see FIG. 10) towards an input port of an optical analyser, for instance a plasma analyser, for instance a spectrometer. The optical fiber may be connected to the monitoring device 150 using for instance an SMA connector 195 (see for example FIG. 1 and FIG. 2).

In particular embodiments of the present invention the housing has a rectangular (or square) cross-section. An example thereof is illustrated in FIG. 3. In this exemplary embodiment at least one first opening 110 is provided on one side of the housing and the at least one mounting point 140 (further called second opening) for mounting the at least one monitoring device 150 is located on the opposite side of the housing 100. The first openings 110 and second openings 140 face one another. It is an advantage of embodiments of the present invention the first opening 110 and the second opening 140 can be easily aligned, e.g. by drilling both holes at once through opposite sides of the housing.

In an embodiment of the present invention the housing 100 may comprise a protective cap 120 which can be mounted on or against the housing 100 at the side of the mounting points 140. This protective cap 120 protects the backside of the one or more monitoring devices 150 sticking out of the housing 100, and the attached optical fibers 190 from being coated or exposed during the deposition or treatment process. In the exemplary embodiment of the present invention illustrated in FIG. 3, the protective cap 120 has a U-shaped or C-shaped cross-section. The size of the cross-section of the housing 100 in this exemplary embodiment of the present invention may range between 20x20 mm and 200x200 mm, and may for example be about 50x50 mm. The thickness of the material of the housing may for example be between 1 and 10 mm, for example about 4 mm. In embodiments of the present invention the housing 100 (possibly including the protective cap 120) can for example comprise a profile or a plurality of profiles made by extrusion.

In embodiments of the present invention a protective sheet 185 is mountable between the first opening 110 and the monitoring device 150. In embodiments of the present invention the protective sheet is made of transparent material, such as for instance glass. The sheet can be moved when it is dirty such that a clean part of the protective sheet moves in front of the lens. An example of a protective sheet 185 is also shown in FIG. 3 and FIG. 4. In this exemplary embodiment it is a protective sheet of glass which can be shifted in the length direction of the housing 100. The protective sheet may be mounted against the housing using an L-profile 180.

FIG. 3 also shows a light guiding element implemented as a bolt 160 according to embodiments of the present invention. Instead of a bolt, a tube could also be used, but the bolt is advantageous in that it is easy to mount and replace. The bolt 160 (or in general the light guiding element) is mounted into the first opening 110 in the housing 100. This can for example be done by screwing the bolt in the first opening 110, for example by using a bolt wrench or a hex key. The bolt 160 has a hole 170 through the bolt, in the longitudinal direction thereof. The bolt 160 thus is a hollow bolt. The collimator lens 150 is mounted in the second opening 140. Both the lens 150 and the bolt 160 are mounted with respect to one another such that radiation from the process chamber entering the housing 100 through the hole 170 in the bolt 160 enters the lens 150. In embodiments of the present invention the focal point of the lens 150 may be somewhere in the hole 170, for instance in the centre of the smallest part of the hole 170 of the bolt 160. From the focal point onwards towards the outside of the housing 100 at the side of the first opening 110, the diameter of the hole 170 in the bolt 160 may be increasing. The increase in diameter of the hole 170 may be continuous or step-wise. In the example illustrated in FIG. 3, the diameter of the hole 170 in the bolt 160 is stepwise increasing. The number of steps may range between 1 and 20 steps, for example between 2 and 5 steps, and may for example be 3 steps. The diameter of the hole 170 and the location of the focus point of the lens 150 determine the area that can be viewed by the lens 150. In embodiments of the present invention the spacing between the mounting points 140 for the monitoring devices 150 is selected based on the area which is viewed by one monitoring device such that the total viewing area is maximized.

In embodiments of the present invention the housing may also be sealed by closing the holes in the light guiding elements 160 (e.g. bolts) using a glass seal.

In embodiments of the present invention, as illustrated in FIG. 13, a plurality of holes 171, 172, 173 may be drilled in the bolt 160, the holes having as end points, end points located on opposite sides of the bolt, wherein the opposite sides referred to here are the opposite sides along the length direction of the bolt. The holes are drilled so that when the bolt is mounted in the housing, the holes are crossing each other at the focal point of the corresponding lens 150 mounted in the housing 100. The advantage of such a configuration is that it is difficult for coating material to reach the lens, while at the same time radiation from different angles can easily reach the lens through the plurality of holes.

FIG. 3 shows an optical fiber 190 connected to the collimator lens 150. This optical fiber 190 is bent and guided to the end of the housing 100, where it leaves the housing 100 to be led to an input port of the plasma analyser. In case of a plurality of monitoring devices 150, e.g. lenses, a plurality of fibers 190 may be guided towards the end of the housing 100. It is thereby an advantage of embodiments of the present invention that the fibers are protected by the protective cap 120. Moreover, they are kept together by the protective cap 120 which is advantageous because this way they cannot disturb the deposition or treatment process.

FIG. 4 shows a cut open 3D-view of the exemplary housing also illustrated in FIG. 3. The protective cap 120 is not completely drawn (the side parts are missing, only the backside is shown) in order to also show the mounted collimator lens 150 and the optical fiber 190. The optical fiber 190 is bending towards an end of the housing. In front of the collimator lens 150 is a protective sheet, for instance a protective glass 185, which can be shifted in front of the lenses. By shifting the protective sheet, e.g. protective glass 185, a clean part of the protective sheet, e.g. glass, will move in front of each of the lenses. In this exemplary embodiment of the present invention the protective sheet, e.g. protective glass 185, is mounted using a L-profile 180. FIG. 4 also shows the perforated bolt 160 mounted in front of the lens 150 in accordance with embodiments of the present invention.

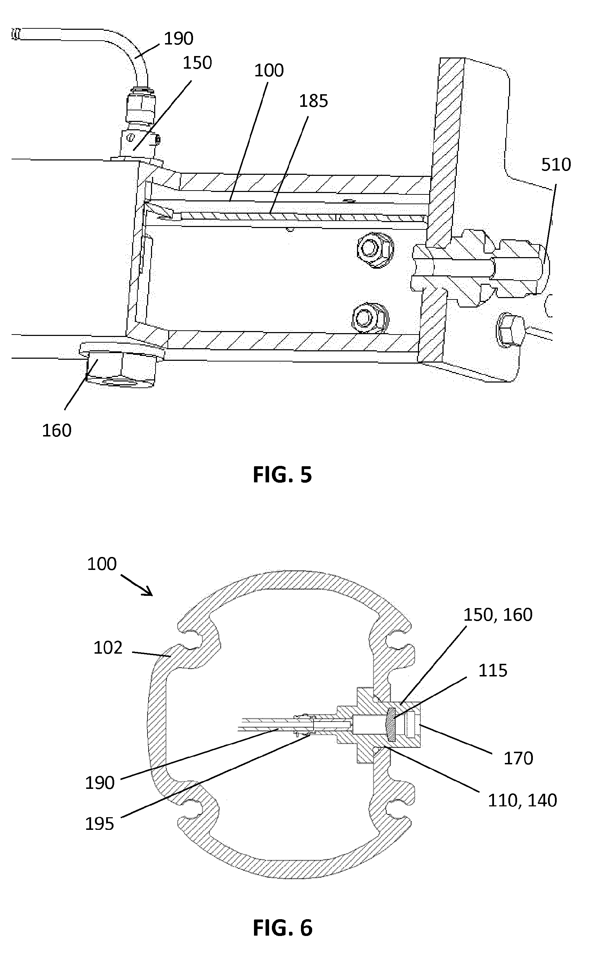

FIG. 5 shows a 3D-view of the same housing as in FIG. 3 and in FIG. 4. FIG. 5 shows one of the two ends of the housing 100. In this exemplary embodiment of the present invention the housing 100 comprises a gas purge connector 510 which is mounted on an end of the housing. This gas purge connector allows to put the housing 100 under pressure, for example under Argon pressure. This pressure is a slight overpressure compared to the pressure in the process chamber and may be regulated by means of a mass flow controller. The pressure is thereby distributed over the at least one first opening 110 or over the at least one bolt 160 when a bolt is mounted in the first opening 110. Because of the pressure difference between the inside and the outside of the housing 100, the gas is blown out of or evacuated from the housing 100 through the at least one first opening 110 or through the at least one hole 170 in the at least one light guiding element, e.g. bolt 160. This outgoing flow prevents that sputtering material enters the housing 100. The optimal pressure difference between the inside and the outside of the housing 100 is a trade-off between, on the one hand, preventing that material (e.g. from the coating process) enters the housing 100 and, on the other hand, preventing that the added gas disturbs the deposition or treatment process.

In embodiments of the present invention the first opening 110 may be the mounting point. An example thereof is illustrated in FIG. 6. In this embodiment of the present invention the light guiding element 160 and the monitoring device 150 are integrated in one piece. Thus emission can reach the monitoring device 150 through the light guiding element 160 in the first opening 110 and the housing 100 protects the monitoring device against contamination or deterioration originating from the process by means of the light guiding element 160. The housing of FIG. 6 comprises a first part 102 which is, in this embodiment of the present invention, a profile of which the cross-section is closed. It can for example be circular or substantially circular. In the first part 102 of the profile the at least one opening 110 is present which is in this case also the mounting point 140. More openings may be spread along the longitudinal direction. In these openings a light guiding element 160 can be mounted which, in this embodiment, is integrated together with the monitoring device 150 in one piece. This light guiding element has a hole 170 through which light (e.g. coming from the plasma) can be guided towards a monitoring device. The monitoring device can for example be the optical fiber 190 in combination with a lens. A glass 115 can be mounted in the light guiding element 160. This glass may be a lens for focussing the incoming light into the optical fiber 190. This glass or lens may be mounted using o-rings, glue or in any other suitable way such that leakage through the hole 170 is avoided. The optical fiber may be connected to the monitoring device 150 using, for instance, an SMA connector 195. In operation, inside this first part 102 an atmospheric pressure can be maintained while at the outside of the first part 102 (in the process chamber) a vacuum may be present.

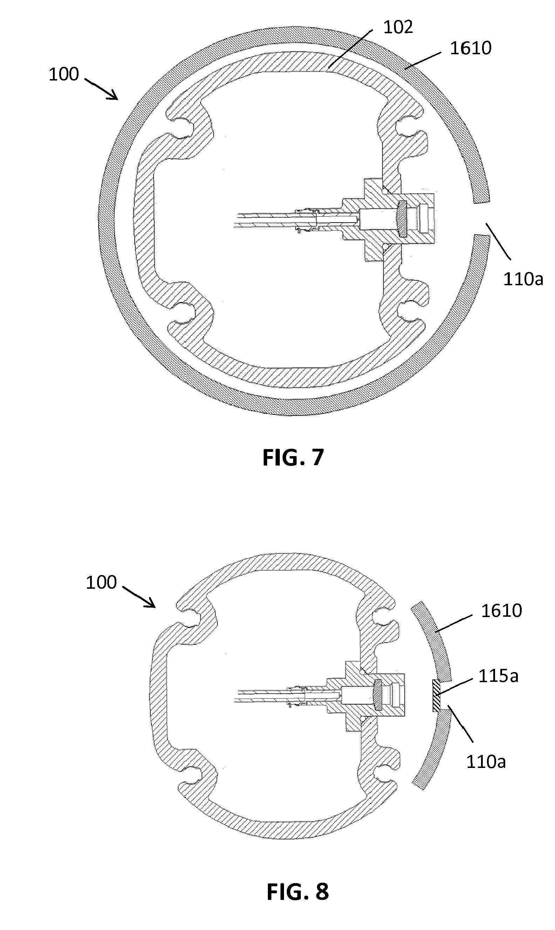

FIG. 7 shows the cross-section of a similar housing as the housing in FIG. 6. The housing in FIG. 7 additionally comprises a second part 1610 also referred to as shielding part 1610. In this exemplary embodiment of the present invention the shielding part 1610 is a profile which is mountable around the first part 102. The shielding part 1610 is movable, e.g. can be shifted in the longitudinal direction with regard to the first part 102 and/or it can be rotated with regard to the first part 102. The shifting and/or rotating can be done using one or more actuators (e.g. using a motor). By positioning the shielding part 1610 with regard to the first part 102 a first opening 110a in the shielding part can be positioned aligned with the hole 170 such that radiation from the process chamber can reach the monitoring device 150 or the first opening 110a can be moved away such that the hole 170 is shielded by the shielding part 1610, depending on the needs. The shielding part 1610 has a same function as protective sheet 185 in FIG. 4. In embodiments of the present invention the shielding part 1610 may have a circular or substantially circular cross-section, in other embodiments it may have flat sidewalls, e.g. it may be rectangular or square in cross-section. In case the shielding part encloses a volume, a purge connector may be present on the shielding part 1610 allowing to over pressurize the enclosed volume to avoid particles entering the volume.

In the exemplary embodiment illustrated in FIG. 8, the shielding part 1610 is illustrated as containing only a portion of the shielding part of FIG. 7. It may effectively consist of only such portion, or it may be a substantially completely closed (except for one or more openings 110a) surrounding shielding part. In this embodiment, a translucent object such as a glass 115a is positioned in the first opening 110a of the shielding part 1610, protecting the monitoring device from contamination.

In the exemplary embodiment illustrated in FIG. 9 a light guiding element 160a is mounted in the first opening 110a of the shielding part 1610 to protect the monitoring device from contamination. Instead of being mounted in front of the first part 102, in this example, the second part (the shielding part) 1610 is mounted around the first part 102. This has constructional advantages. It is for example not only possible to make a first part 102 and a second part 1610 that can shift with regard to each other, but it is also possible to make a first part 102 and a second part 1610 such that the second part 1610 can rotate around the first part 102 or vice versa.

In a second aspect, the present invention provides a deposition and/or treatment system 1000 comprising a housing 100 in a process chamber 1010. The housing is mounted in the process chamber. The ends of the housing 100 may for example be mountable against opposing walls in the process chamber.

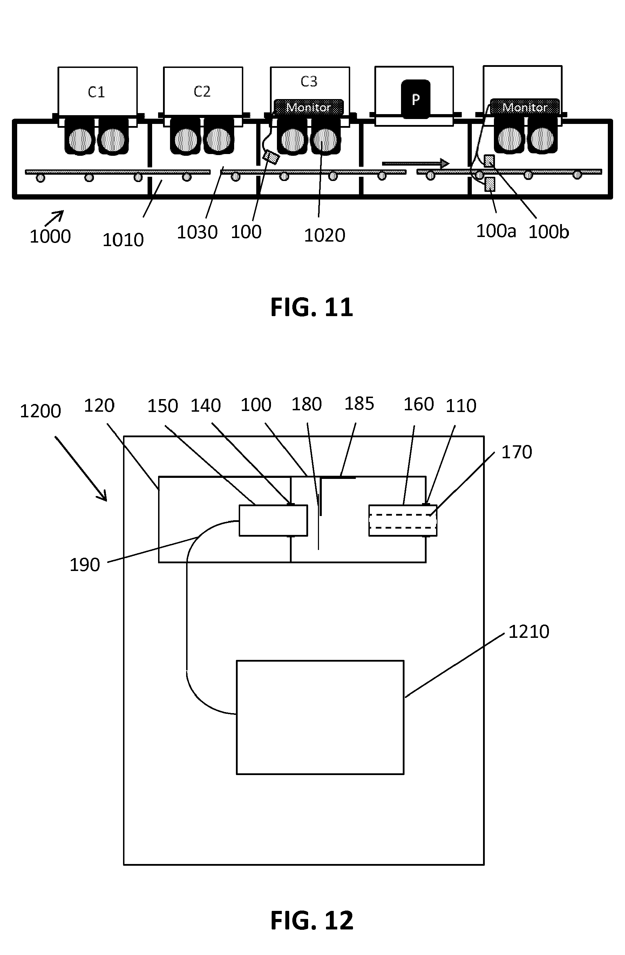

The deposition and/or treatment system may for example be a plasma deposition and/or treatment system (e.g. a sputter setup). The housing 100 may be mounted parallel with a target 1020 in the process chamber. This is in the length direction of the process chamber 1010 (examples thereof are illustrated in FIG. 10 and FIG. 11). FIG. 10 and FIG.11 show a plasma deposition and/or treatment system 1000. The plasma deposition and/or treatment system comprises a housing 100 according to embodiments of the present invention mounted in a process chamber 1010. In the process chamber 1010 targets 1020 are mounted. The figures are schematic drawings of an operational plasma deposition and/or treatment system. A substrate 1030 is moving through the process chamber 1010 while having a coating or treatment process.

The housing 100 can for example be mounted in the chamber at the side opposite to the sputter targets, with respect to the substrate moving through the chamber (e.g. a glass substrate). The housing 100 can be oriented such that the lenses 150 look through the substrate towards the radiation (e.g. plasma, this is illustrated in FIG. 10).

The housing 100 may alternatively also be mounted at the same side of the substrate 1030 as the sputter targets. In that case the housing 100 is oriented such that, during sputtering, the sputtering direction is away from the monitoring device. An illustration thereof is shown in FIG. 11. The monitoring device 150 is inside the housing 100 and can monitor the radiation (e.g. plasma) through a first opening in the housing. Depending on the exact positioning of the monitoring device, the plane defined by the opening 110 and the mounting point 140 along the length of the housing may have an angle varying from being perpendicular to the main deposition direction and being parallel to the main deposition direction. It is an advantage of some embodiments of the present invention that the sputtering direction is away from the monitoring device 150 because thereby the contamination of the monitoring device can be reduced. In embodiments of the present invention where the monitoring device 150 is on the same side of the substrate 1030, the monitoring device may be directly observing the radiation or may be observing the radiation after reflection of the radiation against the substrate. The reflecting set-up may be advantageous in terms of damage of the monitoring device by the active process (e.g. sputtering). The reflecting set-up, however, may require compensation of the measured signal for the changes to the signal caused by the reflection itself.

FIG. 11 also shows an embodiment where a first housing 100a is mounted on one side of the substrate and a second housing 100b is mounted on the opposite side of the substrate. In the first housing 100a a light source may be mounted whereas in the second housing 100b a detector may be mounted. The light coming from the light source goes through the substrate before reaching the detector. Therefore changes in the substrate, causing a variation in the spectrum of the light emitted by the light source and transmitted through the substrate, can be detected by the detector in the second housing.

In embodiments of the present invention, the first housing 100a and the second housing 100b may both be located at the same side of the substrate. This may for example be useful to measure the spectral change in the light generated by a light source and reflected on a substrate or coating. The at least one light source is located in a first housing and the at least one detector is located in the second housing. Such a set-up may for example be advantageous in a configuration in which a flexible substrate (e.g. plastic foil) is winded on a drum and is receiving a coating or treatment. While the substrate is on the drum it is not physically possible to position two housings on opposite sides of the substrate.

In a further embodiment of the present invention, a first housing 100a may contain one or more light sources, and a second and third housing may be present at opposite sides of the substrate. This may be introduced for simultaneously measuring the transmittance and reflectance of a sample passing at a specific position. Instead of a light source and detector, any other monitoring device or combination of monitoring devices may be integrated in the housings.

In embodiments of the present invention a housing 100 can be present on both sides of the substrate 1030. In that case, measured signals at one side can be used to compensate measured signals on the other side. Deterioration of the monitoring devices and the influence of the intermediate substrate can be compensated for.

The housing 100 may be mounted such that it can be oriented in different directions. The first opening 110 may for example be oriented towards the radiation for performing a measurement of the radiation, and it may be oriented away from the radiation for protecting the monitoring device 150. The housing 100 may be translationally or rotatably movable mounted, with its axis of rotation in the length direction of the housing. By rotating, the radiation (e.g. the plasma composition) can be monitored over two dimensions; the first dimension along the length direction of the housing 100, the second dimension orthogonal to the first dimension. By mounting the housing 100 in a rotational manner, the first opening(s) 110 can be rotated away when no contamination is expected. For example, in case of sputtering, when a substrate is present between the plasma monitoring device(s) 150 and the sputter target. This avoids sputtering of material onto the monitoring device(s) 150 , hence reducing contamination of the monitoring device(s) 150 (e.g. lenses). An example thereof is illustrated in FIG. 10. The housing 100 is mounted at the backside of the substrate 1030 such that the monitoring devices 150 see the radiation (e.g. plasma) through the substrate 1030. By rotating the housing 100, the radiation can be monitored over a wider range than would be the case for a fixed housing. When monitoring the radiation, the monitoring device 150 is protected by the housing 100, by the bolt 160, and by the substrate 1030. In the exemplary embodiment illustrated in FIG. 10 the housing 100 can rotate away when no substrate 1030 is present to protect the monitoring device 150 against contamination by the sputtering process.

In embodiments of the present invention a plurality of housings 100 may be mounted parallel with each other. This allows determining the radiation (e.g. plasma composition) in a direction orthogonal to the length direction of the housing.

The at least one optical fiber 190 connecting to the monitoring device 150 is bent and guided to an end of the housing 100. There may be a plurality of fibers. In order to get them connected to an optical fiber outside the process chamber, a flange may be used (e.g. a KF 40 flange). The flange may have optical connectors on both sides to which a fiber can be connected. From one side to the other side this may be a direct feedthrough 1410. Multiplexing is also possible. Thereby, a light guiding element, e.g. a prism, mirror or moving/rotating fiber, may be used to transfer the signal from one fiber to another fiber. By changing the position of the light guiding element (e.g. prism, mirror or moving fiber) relative to the fixed fibers, a different connection between fibers can be made. By multiplexing, the number of spectrometers can be reduced at the expense of measurement time. When doing for example 16x1 multiplexing, 16 input channels are multiplexed onto one output channel. The measurement time is thereby increased with a factor 16; the number of required spectrometers is, however, reduced with a factor 16. For slowly varying systems, multiplexing is allowable and has the advantage that less spectrometers are required. Each of the different input channels is for example connected with a lens which is monitoring the radiation (e.g. plasma) at a different location.

In a third aspect the present invention provides a measurement system 1200 for determining the composition of the radiation (e.g. the plasma) in a process chamber. The measurement system comprises a housing 100 which is mountable in the process chamber. The measurement system 1200 moreover comprises at least one monitoring device 150 which is mountable in the housing 100. The measurement system moreover comprises a processing system 1210 adapted for processing the measurement signals (e.g. measured spectrum) thereby determining physical properties of the radiation (e.g. plasma) monitored by the monitoring device 150 (see for example the measurement system illustrated in FIG. 12).

The monitoring device 150 may for example monitor an optical signal, for example the spectrum of the optical signal between 350 nm and 1000 nm.

The physical properties may be the gas composition (e.g. the partial pressure) of the different gases which are present in the process chamber. In embodiments of the present invention the processing system is configured to obtain the partial pressures of all gases in the process chamber and this at different locations in the process chamber.

In embodiments of the present invention the processing system 1210 is configured to determine whether a deviating composition or leakage is present in the process chamber 1010. This can be done based on the changes in partial pressure of the gasses in the process chamber.

By monitoring and timestamping the variations of the partial pressure obtained by the processing system 1210 a log of these variations can be tracked. In embodiments of the present invention these variations can be tracked for different positions within the process chamber 1010. It is an advantage of embodiments of the present invention that the quality of the deposited layer can be compared with the composition of the gas in the process chamber while sputtering.

In embodiments of the present invention where the radiation (e.g. plasma) is looked at through the glass substrate, the measured spectrum is not the spectrum of the radiation per se, but the spectrum of the radiation influenced by the partially sputtered glass substrate.

In embodiments of the present invention, the analysis of the measurement signals (e.g. measured spectrum) by the processing system 1210 is performed taking into account that a substrate (e.g. a glass substrate) is present e.g. in between the measurement device and the radiation. To determine the composition of the radiation (e.g. plasma) based on the measurement signals (e.g. measured spectrum), an analysis of the measurement signals neutralizing the influence of the substrate is required. This influence may even change while sputtering because of the sputtered coating on the substrate 1030.

One possibility is to determine the relationship between predetermined peaks in the spectrum. In embodiments of the present invention the processing system is configured to carry out an analysis of the ratio of peaks. When the ratio between predetermined peaks changes (e.g. the ratio between oxygen and argon peaks), this may be due to a change in composition of the gas. A large reduction of the strength of certain spectral peaks or an overall intensity can indicate contamination of the lens.

In embodiments of the present invention the processing system is configured to take into account the influence of the substrate 1030 (e.g. glass substrate) at each wavelength of the spectrum when evaluating the measured spectrum. The influence of the substrate can be estimated (e.g. through calibration measurements) in advance.

In embodiments of the present invention the angle over which the housing 100 is rotated can be controlled by the processing system 1210. The processing system 1210 can therefore change the rotation angle, subsequently do a measurement and do this until the radiation is scanned by the housing over the range which can be scanned by the housing.

In embodiments of the present invention the processing system is adapted for controlling various parameters of the process as to tune the conditions depending on the measurements. This may be for instance the gas-supply of the different gases based on the measured gas composition or the magnetic field strength of a magnetron system based on the reflectance or transmittance measurement of the coated/treated substrate. It is an advantage of embodiments of the present invention that the closed loop control of a process parameter (e.g. the gas composition, magnetic field strength, pumping capacity, plasma power) is possible.

FIGs. 14, 15 and 16 show measurement systems in accordance with embodiments of the present invention.

In the exemplary embodiment of the present invention illustrated in FIG. 14, the fibers coming from the monitoring devices 150 are leaving the process chamber using a feedthrough component 1410. These fibers are connected to a spectrometer and processing system 1210. The feedthrough component 1410 closes the hole 1420 in the wall of the process chamber such that a vacuum can be created in the process chamber while the outside of the process chamber is at atmospheric pressure. The housing 100 may for instance be as illustrated in detail in FIG. 3, with a first opening 140 for mounting a monitoring device 150 and a second opening 110 aligned therewith for mounting a light guiding element 160. In this example a gas purge connector 510 is mounted on the housing 100.

In the exemplary embodiment of the present invention illustrated in FIG. 15, a first end 1510 of the housing 100 is open. This end is mounted against the opening 1420 in the wall of the process chamber, and sealed from the inside of the process chamber. The second end 1520 of the housing is closed. The other openings in the housing 110 are sealed such that a vacuum can be created in the process chamber while the outside of the process chamber is at atmospheric pressure as well as the inside of the housing 100. The housing 100 may for instance be a housing as illustrated in FIG. 1. The connection from the housing 100 to the opening 1420 may be realized by any means known from the state-of-the-art; such as tubing, bellows, hoses or the like or a combination of those, being rigid or flexible.

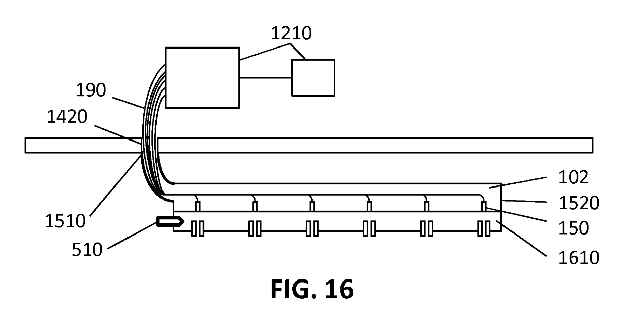

In the exemplary embodiment of the present invention, illustrated in FIG. 16, a first end 1510 of a first part 102 of the housing 100 is open. This end is mounted against the opening 1420 in the wall of the process chamber, and sealed from the inside of the process chamber. The second end 1520 of the first part 102 of the housing is closed. The other openings in the first part 102 of the housing 110 are sealed such that a vacuum can be created in the process chamber while the outside of the process chamber is at atmospheric pressure as well as the inside of the first part 102 of the housing 100. The housing 100 may for instance be a housing as illustrated in FIG. 2 or FIG. 7. The housing 100 moreover comprises a second part 1610, which in the embodiment illustrated comprises a purge connector 510, in accordance with embodiments of the present invention. Particles can be prevented from entering the second part 1610 by over-pressurizing this second part 1610 through the purge connector 510. Thus contamination of elements (e.g. glass elements, lenses) in the first part 102 and in the second part 1610 is prevented.

## Claims

1. A housing (100) for mounting a monitoring device (150) in a process chamber, the housing comprising a first opening (110) and a mounting point (140) adapted for mounting a monitoring device (150), wherein the first opening (110) and the mounting point (140) are positioned such that,
- when the monitoring device (150) is mounted in the housing (100) at the mounting point (140),
- and when the housing (100) is mounted in the process chamber,
during processing, emission from the process chamber can reach the monitoring device (150) through the first opening (110) and such that the housing (100) protects the monitoring device against contamination or deterioration originating from the process.

2. A housing (100) according to claim 1, comprising a light guiding element (160) mounted into the first opening (110) in the housing (100) wherein the light guiding element (160) is hollow in its longitudinal direction and when a monitoring device (150) is mounted in the housing, emission from the process chamber can reach the monitoring device through the light guiding element.

3. A housing (100) according to claim 2, wherein the light guiding element is a bolt (160) having a hole (170) in its longitudinal direction.

4. A housing (100) according to any of claims 2 or 3, wherein the first opening (110) is the mounting point (140).

5. A housing (100) according to any of claims 1 to 3, the housing comprising a second opening (140) on the side of the housing opposite to the side of the first opening (110) wherein the second opening (140) is the mounting point (140).

6. A housing (100) according to any of the previous claims, the housing (100) comprising a protective sheet (185) mountable between the first opening (110) and the mounted monitoring device (150) or mountable in front of the first opening (110) and the monitoring device (150).

7. A housing (100) according to any of the previous claims wherein the housing (100) is an elongated housing comprising a plurality of first openings (110) and mounting points (140) such that emission from the process chamber can reach a plurality of monitoring devices (150) when they are mounted at the mounting points (140) of the housing (100).

8. A housing (100) according to any of the previous claims, the housing comprising a gas purge connector (510).

9. A housing (100) according to any of the previous claims, wherein at least a first part (102) of the housing has an opening (1510) which is mountable against an opening in the wall of the process chamber and wherein this first part (102) of the housing (100) is sealed from the process chamber, such that when the housing (100) is mounted in the process chamber with the opening (1510) sealed against the opening of the process chamber, a pressure difference can be present between this first part (102) of the housing and the process chamber and such that this pressure difference will not result in a gas flow from the inside of the first part (102) of the housing into the process chamber.

10. A housing (100) according to any of the previous claims, the housing comprising a first part (102) comprising the mounting point (140) for mounting the monitoring device (150) and comprising a second part (1610) comprising the first opening (110a) wherein the second part (1610) can be mounted around or in front of the first part (102) and wherein the second part can be shifted in the longitudinal direction and/or rotated with regard to the first part such that, when the housing (100) is mounted in the processing chamber, during processing, the opening (110a) in the second part (1610) can be positioned such that emission can reach the monitoring device (150) through the first opening (110a) or the first opening (110a) can be moved away such that the shielding of the monitoring device (150) by the second part (610) is enhanced.

11. A deposition and/or treatment system (1000) comprising a housing (100) according to any of the previous claims mounted in a process chamber (1010) such that, in operation, the at least one first opening (110) in the housing is orientable towards the emission such that when a monitoring device (150) is mounted in the housing it has a viewing angle on the emission from within the process chamber.

12. A deposition and/or treatment system (1000) according to claim 11, wherein the housing (100) is translationally or rotatably movable mounted in the process chamber.

13. A deposition and/or treatment system (1000) according to any of claims 11 or 12, wherein the housing (100) is mounted such that, in operation, when a substrate (1030) is in the process chamber (1010), the substrate (1030) is in between the emission source and the housing (100), or the emission source and the housing (100) are at the same side of the substrate (1030).

14. A measurement system (1200) for determining emission characteristics in a process chamber (1010), the measurement system comprising:
- a housing (100) according to any of the previous claims 1 to 14, the housing being mountable in the process chamber (1010),
- at least one monitoring device (150) mountable in the housing (100) and adapted for measuring the spectrum of the emission,
- a processing system (1210) adapted for processing a measurement signal measured by the at least one monitoring device (150), thereby determining physical properties of the emission monitored by the monitoring device (150).

15. A measurement system (1200) according to claim 14, wherein the processing system (1210) is adapted for controlling the position of the housing in the process chamber (1010).
